# EUROPEAN PATENT SPECIFICATION

(11) **EP 4 630 828 B1**
(45) Date of publication and mention of the grant of the patent: **30.09.2026**
(21) Application number: 23701643.1
(22) Date of filing: 19.01.2023
(51) Int. Cl.: G01R 19/25, G01R 29/18, G06N 20/00, H02J 13/00

(54) **METHOD AND SYSTEM FOR ONLINE PASSIVE DETECTION OF PHASE CONNECTION OF POWER METERS**
VERFAHREN UND SYSTEM ZUR PASSIVEN ONLINE-ERKENNUNG DES PHASENANSCHLUSSES VON STROMZÄHLERN
PROCÉDÉ ET SYSTÈME DE DÉTECTION PASSIVE EN LIGNE DE CONNEXION DE PHASE DE WATTMÈTRE

(30) Priority: 07.12.2022 IN 202211070539
(43) Date of publication of application: 15.10.2025
(73) Proprietor: Eaton Intelligent Power Limited, D04 Y0C2 Dublin 4 (IE)
(72) Inventor: CUNNINGHAM, Nathan, Dublin, D11 K79X (IE); SONI, Nimish Navin, Mumbai 400093 (IN); LOOMBA, Radhika, Dublin, D13 Y6NK (IE)
(74) Representative: Collingwood-Pierce, Alexandra Isobel Seymour
(86) International application number: PCT/EP2023/051206
(87) International publication number: WO 2024/120658

(56) References cited:
- US-A1- 2021 285 994
- WANG WENYU ET AL: "Phase Identification in Electric Power Distribution Systems by Clustering of Smart Meter Data", 2016 15TH IEEE INTERNATIONAL CONFERENCE ON MACHINE LEARNING AND APPLICATIONS (ICMLA), IEEE, 18 December 2016 (2016-12-18), pages 259 - 265, XP033055533, DOI: 10.1109/ICMLA.2016.0050
- SYED DABEERUDDIN ET AL: "Smart Grid Big Data Analytics: Survey of Technologies, Techniques, and Applications", IEEE ACCESS, IEEE, USA, vol. 9, 27 November 2020 (2020-11-27), pages 59564 - 59585, XP011851410, DOI: 10.1109/ACCESS.2020.3041178
- HOSSEINI ZOHREH S ET AL: "Machine Learning-Enabled Distribution Network Phase Identification", IEEE TRANSACTIONS ON POWER SYSTEMS, IEEE, USA, vol. 36, no. 2, 22 July 2020 (2020-07-22), pages 842 - 850, XP011839326, ISSN: 0885-8950, [retrieved on 20210218], DOI: 10.1109/TPWRS.2020.3011133

## Description

### Field of Disclosure

The field of this disclosure relates to methods and systems for detecting phase connections of power meters. In particular, to methods and systems for online passive detection of phase connection of power meters on feeder power lines of an electricity distribution network.

### Background

Electricity distribution networks consist of substations connected to multiple feeders which distribute electricity to the end consumers. The network is largely three-phase in most countries, while the phase at the end consumer can consist of single-phase (residential), two-phase, and multi-phase (commercial and industrial) loads. The network is designed to operate at maximum efficiency when the three phases are balanced. This requires planning and distributing single-phase and two-phase loads across the three phases of feeder power lines of the network such that the overall demand is balanced.

Planning software used by utilities make use of network configuration data. The data can include network settings, policies, controls, as well as phase connections of each of the meters on the network. Inaccurate phasing information can, therefore, lead to poorer planning and a suboptimal network. The planning software uses the information in predicting the extent of an outage such that swifter outage management can be enabled. Therefore, inaccurate information leads to inadequate outage management, with misidentified phase connections leading to longer outages and requiring overtime from engineers to address, resulting in dissatisfied customers.

Other issues that arise are errors in the phase model of the network planning software. While these errors are rare, they tend to accumulate over time leading to significant network issues later. Also, power lines may be incorrectly installed on a phase other than their intended one or reconnected to a different phase following a downed power line due to, for example, a storm.

Further, some utilities make use of hardware to identify the phase connection of a meter. This can be slow, requiring an engineer to manually assess the phase connection of individual meters. The hardware and manpower costs can ultimately mean this is a reactive approach, only taken after an issue has been identified. Further, some meters require injecting a signal on each meter and measuring the time until the voltage hits zero. Injecting a signal requires specific capabilities in the meter for the purposes of phase detection, thus has limited function.

There has been attempts to mitigate these issues and provide better determination of phase connection such as that disclosed in Therrien et al, Assessment of Measurement-Based Phase Identification Methods, IEEE Open Access Journal of Power and Energy, Volume 8, p128, March 2021. However issues still persist in accurately detecting the phase connection, with current methods requiring somewhat extensive and complicated algorithms. Therefore, there is a need for more accurate determination of phase connection, while providing a simple and efficient implementation into the electricity distribution network.

US 2021/285994 A1 relates to techniques for phase identification using feature-based clustering approaches

### Summary

In this disclosure, there is provided a passive phase connection detection method for feeder power lines of an electricity distribution network, the method comprising: acquiring a list of meters for each feeder power line of the electricity distribution network; acquiring presumed phase connection data and historic voltage data of each meter of the list of meters of each feeder power line; assigning weight values to the presumed phase connection data to each meter of the list of meters of a first feeder power line; initiating an analysis algorithm when new voltage data is detected for a first meter of the first feeder power line, wherein the analysis algorithm comprises: calculating, for the first meter, the change in voltage between new voltage data and historic voltage data; identifying, for the first meter, the phase connection of the meter based on the voltage difference of neighbouring meters of the list of meters of the first feeder power line that are within a predetermined threshold number of the nearest neighbour meters; incrementing the assigned weight values of the phase connection of the first meter if the identified phase connection is most common amongst the nearest neighbouring meters; assigning the meter to the phase connection with greatest assigned weight; and repeating the analysis algorithm for a next meter of the first feeder power line.

The analysis algorithm may be performed for all feeder power lines of the electricity distribution network. This allows the phase connection of the whole or part of the electricity distribution network to be determined, and thus lead to better planning of the power distribution within the network.

The method may be implemented online, such that the analysis algorithm processes the data incrementally as new data arrive. This allows the method to be passive and reduce or mitigate the need for user intervention as the system can communicate information and instructions across the system architecture.

The change in voltage may be positive, or the change in voltage may be negative.

The change in voltage for each meter may relate to a common time interval. This ensures that the change in voltage between a meter and the neighbouring meters are acquired at the same time interval, to accurately compare the change in voltage values.

The phase may be selected from the range: single-phase; two-phase; three-phase; or any suitable combination. Thus, the method can be implemented on any electrical distribution network.

The electricity distribution network may be an advanced metering infrastructure, AMI, network. The AMI has the ability to remotely collect a customer's real-time electricity usage and other information via a two-way communication system providing the capability to manage services and power demand, resulting in an overall more efficient electricity distribution network system.

The electricity distribution network may consist of meters selected from the range: radio frequency, RF, meters, Wi-Fi meters, cellular-type meters or the like, enabling electrical energy measurements to be obtained and communicated to a central gateway or server database of the electricity distribution network.

The presumed phase connection data and historic voltage data of each meter may be acquired from a database on the electricity distribution network and/or from the internal memory of the meter. Having the information already stored on the system allows the analysis algorithm to be triggered at a selected time interval, thus reducing computational resources. For example, the data may be collated by the system every hour whereas the analysis algorithm may be triggered every 24 hours, or every few days, or longer.

The method may further comprise identifying the phase connection of a subset of meters on each feeder power line based on the meters within a predetermined threshold number of nearest neighbour meters.

The subset of meters on each feeder power line may be substantially the square root of the total meters on the feeder..

The weight values may be selected such that meters with a high degree of confidence of the presumed phase connection have a higher weight value than meters with a low degree of confidence of presumed phase connection..

The detection of the new voltage data may be set to trigger at fixed time intervals. Having fixed time intervals means that the analysis is performed at regular intervals, again reducing computational resources.

The time intervals may be less frequent than the data acquisition of the data stored in the database on the electricity distribution network. This allows the time intervals to be set at longer intervals than the acquisition of the data on the electricity distribution network, reducing the frequency of the analysis, and thus reducing the computational processing requirements.

The method may further comprise updating the phase associations for each meter. This keeps the phase association information for the analysed meters up to date, such that changes in the phase connection can be identified and the planning of the power distribution within the network is more accurate.

The updated phase associations for each meter may be stored in the database on the electricity distribution network.

In this disclosure, there is provided a passive phase connection detection system method for feeder power lines of an electricity distribution network, the system comprising: an electricity distribution network; a communication module; a data acquisition and management module; a database; a plurality of meters associated with a plurality of feeders; and a computational device, wherein the computational device comprises one or more processors which are configured to perform a passive phase connection detection method.

This invention proposes a method for passively identifying the connected phase of an electrical meter in near real-time using the voltage data recorded by utilities via advanced metering infrastructure (AMI).

The invention solves the problem of uncertainty in the connected phase of an electric connection using a passive, online algorithm which updates meter-phase connection data in near-real-time. The data required for the algorithm are already measured and stored by utilities, and the algorithm is lightweight, and so adds minimal workload to the processing of these data. The proposed approach requires no additional hardware other than a smart meter capable of recording and reporting voltage data and the computational resources necessary to store and process these data.

Furthermore, this approach is passive and 'online' in that phase connections are inferred regularly using the most recent data and does not require manual intervention from the utility. The proposed method works with any smart meter capable of measuring and reporting voltage data.

### Brief Description of Drawings

The disclosure will be described, by way of example only, with reference to the accompanying drawings, in which:
Fig. 1 illustrates a schematic diagram of components of the system architecture; and
Fig. 2 illustrates a flow diagram of the method steps for online passive detection of phase connection of power meters.

### Detailed Description

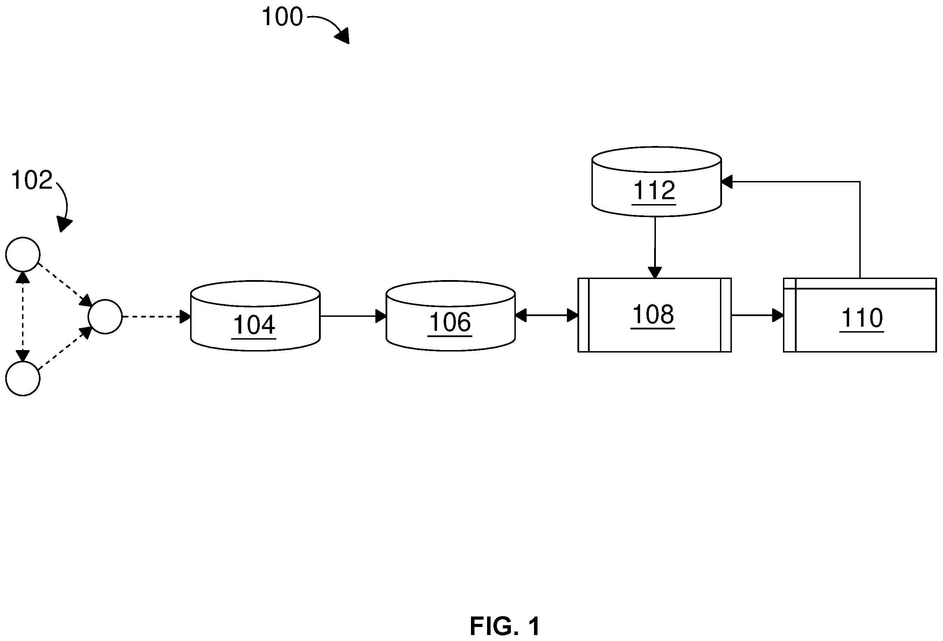

Fig. 1 illustrates a schematic diagram of a system architecture 100. The system architecture 100 comprises a network 102, preferably a smart network 102, comprising a plurality of feeder power lines with a plurality of power meters. The smart network may consist of radio frequency (RF) meters configured on a RF mesh network, or Wi-Fi meters, or cellular-type meters or the like such that data can be communicated across the electricity distribution network. The meters on each feeder relate to individual endpoints, for example in a home or commercial building or the like, and are capable of recording measurements of electrical activity at the endpoint, for example power consumed, voltage, current, etc. The meters also have the function to remotely transmit this information to a centralized gateway 104, as shown in Fig. 1, through any known communication means such as TCP/IP or User Datagram Protocol/IP. The central gateway 104 then transmits the data to the data acquisition and management software 106. The meters may also communicate directly with a database on a server of the electricity distribution network. The data acquisition and management software 106 communicates with the meter on the smart network 102 such that the data is sent at fixed regular time intervals to the software, such as every 15 minutes, every 30 minutes, every hour, every 2 hours, or so. The acquired data may be stored in a database on the electricity distribution network. The utilities may maintain their own database on the physical configuration of the network, external to the system architecture 100, including the phase to which each customer is connected. The utilities data repository is typically updated much less frequently than the database of the electricity distribution network.

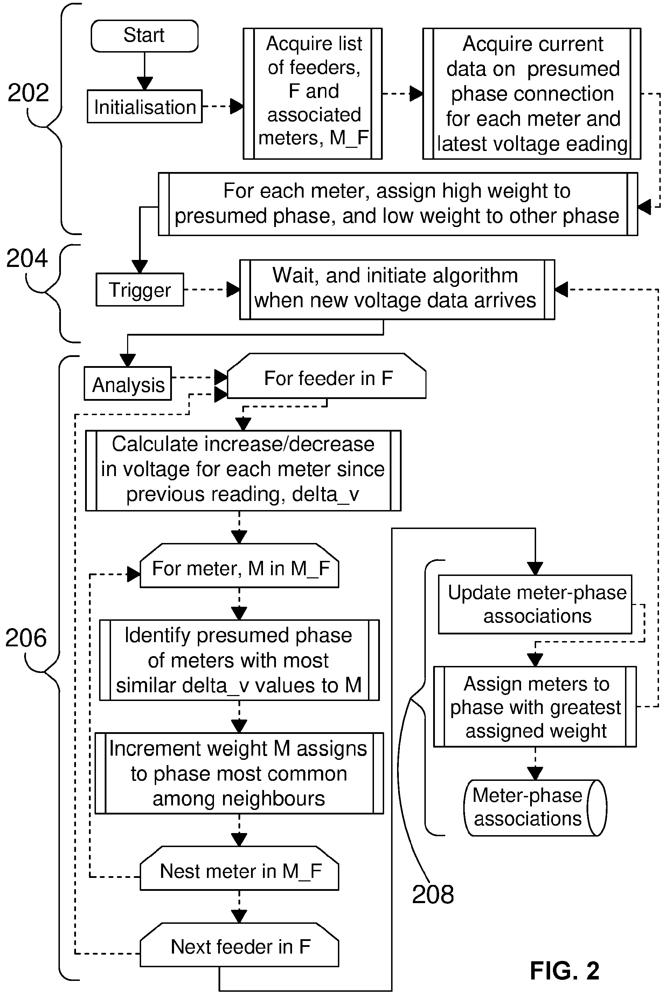

The smart network 102 allows the system 100 to monitor, manage and predict the performance and power requirements across the electricity distribution network such that the network is balanced and operating efficiently. In order to improve the efficiency and mitigate errors in the phase connection across the electricity distribution network, a passive phase detection system is integrated with the electricity distribution network. This is illustrated in Fig. 1 as the phase detection algorithm 108 and the updated phase labels database 110. The phase detection is preferably executed online, i.e. the data is processed as new data arrive, with the phase detection algorithm 108 and the updated phase labels database 110 in communication with the electricity distribution network. The phase detection algorithm 108 acquires voltage data from the data acquisition and management software 106. The phase detection algorithm 108 performs the analysis on the acquired data according to the phase connection detection method (which is discussed in relation to Fig. 2). The phase detection algorithm 108 then stores the phase connections for each of the meters on each of the feeder power lines in the updated phase labels database 110. Once the analysis is complete at that particular time interval, the updated phase labels database 110 feeds the updated phase connection data into the data repository 112, such that the model can be adjusted depending on if any phase changes have occurred on any of the measured meters. The system architecture 100, as illustrated in Fig. 1, illustrates the data repository 112, wherein utilities can access and maintain the information on the physical configuration of the network.

Fig. 2 illustrates a flow diagram 200 of the method steps for passive detection of phase connection of power meters of feeder power lines of an electricity distribution network. The method automatically ensures the most up-to-date assignment of meters to phases. As discussed in relation to Fig. 1, the method integrates into existing data lines of an electricity distribution network, adding a small, lightweight analysis step into current system architectures 100 of an electricity distribution network. The method relies on the knowledge that meters connected to different phases will exhibit different voltage patterns owing to being at different point, i.e. different phase, in the voltage cycle. The first initialisation step 202 involves assigning large weight values to the currently presumed phase for each meter. This information is typically available from the electricity distribution network model, although with some errors. The idea of these weights is to seed the algorithm with our current knowledge of the state of the network. These weights can be varied for each meter to reflect the degree of confidence we possess about the current phase of the meter, i.e. a high degree of confidence of the presumed phase connection will be assigned a higher weight value than meters with a low degree of confidence of presumed phase connection. As shown in step 202 the phase detection algorithm 108 acquires a list of feeder power lines, i.e. feeders (F), and the meters associated with each of the feeders (M_F) on the electricity distribution network. Once the information on the feeders (F) and meters (M_F) have been acquired, data on the presumed phase connection for each meter is acquired according to the current status of the network, along with the latest voltage reading. This data may be acquired from the data acquisition and management software 106 and/or from a data store on the electricity distribution network. For each meter on each feeder power line weight values are assigned based on the accuracy of the presumed phase. For example, a recently checked meter will have a high weight value assigned to the presumed phase connection as the assignment of the phase is likely to be correct given the recent checking of the meter.

An example of the initialisation step 202 applied to a simple scenario is provided. The scenario can be thought of as a utility comprising eight single-phase household customers each with a smart meter streaming usage information to a central repository. Following installation of these meters, their phase connections are stored in a static repository. An initial table of meters, their currently assumed phase labels, and associated weights is created. A weight of 30 is assigned for phase A which means a meter would need to be identified at least 30 times as belonging to a different phase for it to be reclassified as a different phase. The choice of initial value for the weights can be tailored to reflect knowledge of the state of the network. For example, a meter which has recently been verified as being on phase A could be assigned a greater weight than other meters. In this example, the utility currently believes it has three phase A, two phase B, and three phase C meters, each sharing an equal weight as shown in the table below (Table 1).

**Table 1: Assigning weights to different phases for meters with presumed phase connection.**

| **Meter ID** | **Phase weight** | | |
|---|---|---|---|
| | **A** | **B** | **C** |
| Meter 1 | 30 | 0 | 0 |
| Meter 2 | 30 | 0 | 0 |
| Meter 3 | 30 | 0 | 0 |
| Meter 4 | 0 | 30 | 0 |
| Meter 5 | 0 | 30 | 0 |
| Meter 6 | 0 | 0 | 30 |
| Meter 7 | 0 | 0 | 30 |
| Meter 8 | 0 | 0 | 30 |

The next step of the method 200, as illustrated in the flow diagram of Fig. 2, is the triggering of an analysis algorithm 204. The analysis algorithm 204 waits until a new voltage data arrives for a first meter of a first feeder power line, or for all meters of a first feeder power line. Once the new voltage data is detected the analysis algorithm is initiated, as shown in step 206 of the flow diagram 200 of Fig. 2. The triggering of the analysis algorithm may be performed manually, i.e. not passively, if required. The analysis algorithm 206 commences by calculating the difference between the new voltage data and the previous or historic voltage reading, as attained from the data acquisition and management software 106 and/or from a data store on the electricity distribution network, for the first meter of the first feeder power line. Similarly, calculating the difference between the new voltage data and the historic voltage data can be performed for each of the meters of the first feeder power line. The analysis algorithm 206 calculates if there is an increase or decrease in the voltage between the two readings. The analysis algorithm then identifies the phase connection of the first meter based on neighbouring meters of the list of meters on the feeder power line. The phase connection is identified for the first meter when the first meter and neighbouring meters are within a predetermined threshold change in voltage, or for each of the meters of the first feeder power line. It is necessary that the voltage difference values for each meter relate to a common time interval.

Using the same simple scenario of a utility comprising eight single-phase household customers as given above, the voltage differences and neighbour phases are stored in a data store or repository on the electricity distribution network. A second table of each of the meters on the feeder power line is created with such data. The example data is provided in Table 2 below.

**Table 2: Calculated voltage difference, identified nearest neighbour and nearest neighbour phase for each meter.**

| **Meter ID** | **Voltage difference** | **Nearest neighbours** | **Neighbour phase** |
|---|---|---|---|
| Meter 1 | +1.2 | Meter 2, Meter 3, Meter 4 | **A, A,** B |
| Meter 2 | +0.9 | Meter 1, Meter 3, Meter 4 | **A, A,** B |
| Meter 3 | +1 | Meter 1, Meter 2, Meter 4 | **A, A,** B |
| Meter 4 | +1.1 | Meter 1, Meter 2, Meter 3 | **A, A, A** |
| Meter 5 | -0.2 | Meter 6, Meter 7, Meter 8 | **C, C C** |
| Meter 6 | -0.35 | Meter 5, Meter 7, Meter 8 | B, **C, C** |
| Meter 7 | -0.3 | Meter 5, Meter 6, Meter 8 | B, **C, C** |
| Meter 8 | -0.25 | Meter 5, Meter 6, Meter 7 | B, **C, C** |

The set of nearest neighbour meters may be selected as a subset of all meters on the feeder power line, i.e. those with the most similar voltage differences. The size of the subset of meters depends on the overall total number (N) on the feeder power line, i.e. the number of customers on the same feeder. A subset may be chosen as the square root of the total number of meters on the feeder power line, i.e. √*N.* In the example shown in Table 2, three nearest neighbour meters are chosen as the subset for the analysis, which is approximately √8. Other number of nearest neighbours (k) in a k-nearest neighbour algorithm can be chosen using other selections means, such as other known heuristics or a fixed value depending on the sample set of data. As shown in Table 2, the voltage difference for Meter 1 is calculated to be +1.2 V and the nearest neighbour meters to Meter 1 within the chosen subset of meters are Meter 2, Meter 3 and Meter 4, with their phase connections being A, A and B, respectively. Thus, Meter 1 is assigned phase label A due to the A being the most common phase amongst the closest neighbouring meters. This aligns with the presumed phase connection of Meter 1 as shown in Table 1. However, from the analysis in Table 2, Meter 4 has three nearest neighbour meters all with phase A whereas from Table 1 the presumed phase connection is phase B for Meter 4. Thus, there may be an error in the presumed phase connection for Meter 4.

To assess if there is an error in the presumed phase connection of a meter the weight values are incremented for the phase most common to the nearest neighbours of the meter. Thus, the analysis algorithm 206 increments the assigned weight values of the phase connection of the first meter if the identified phase connection is comparable to the neighbouring meters. For example, +1 is added to the weight value of the phase of each meter which has the most common phase amongst the neighbouring meters. For example, using the same simple scenario of a utility comprising eight single-phase household, Meter 1 would have +1 added to phase A weight value. This is the case as the analysis algorithm 206 acquired the presumed phase connection for Meter 1 as phase A, as shown in Table 1, and from further analysis the data in Table 2 indicates that the phase most common amongst the nearest neighbours for Meter 1 is also A. Therefore, Meter 1 gets +1 added to phase A weight, resulting in a weight value of 31. However, for Meter 4 it was determined that the presumed phase connection was B (Table 1) but the analysis returned phase A (Table 2), due to all the nearest neighbour meters having a phase connection of phase A, the +1 is added to phase A weight value. Thus, Meter 4 has phase A with weight value 1, and phase B with weight value 30. This is shown in Table 3 below.

**Table 3: Incrementing weight values based on nearest neighbour phase analysis.**

| **Meter ID** | **Phase weight** | | |
|---|---|---|---|
| | **A** | **B** | **C** |
| Meter 1 | 31 | 0 | 0 |
| Meter 2 | 31 | 0 | 0 |
| Meter 3 | 31 | 0 | 0 |
| Meter 4 | 1 | 30 | 0 |
| Meter 5 | 0 | 30 | 1 |
| Meter 6 | 0 | 0 | 31 |
| Meter 7 | 0 | 0 | 31 |
| Meter 8 | 0 | 0 | 31 |

Following the analysis for the first meter, the analysis algorithm 206 assigns the meter to the phase connection with greatest assigned weight, storing the result in the data store, and then repeats the analysis for the next meter and subsequent meters of the first feeder power line. Once the analysis algorithm 206 performs the analysis for each of the meters on the first feeder power line, the analysis algorithm 206 repeats the analysis for all the feeders on the electricity distribution network. The data is collated for all meters on all feeder power lines and the assigned labels for each meter are updated to the phase with the greatest weight, as shown in step 208 of Fig. 2. As a new voltage data arrives, the method steps 204 and 206 are repeated. From discussions above, the arrival of new voltage data may be set at regular intervals.

Again using the example of the eight single-phase household customers, the phase label assigned to Meter 4 would remain as phase B until 30 more iterations of the phase being A has been determined before the meter can be assigned to a new phase label, i.e. becomes the phase with the greatest weight value. For example, after 30 more iterations Meter 4 would have phase weight values of A = 31, B = 30 and C = 0. At the same time if Meter 1 continued to be determined as phase A through the 30 more iterations Meter 1 would have phase weight values of A = 61, B = 0 and C = 0. It will be realised that depending on the frequency of detecting the new voltage data, the initial weight values for the phase connections may vary. For example, if selected to trigger, i.e. sample new voltage data, every 1 hour then the initial weight values may be a higher than those chosen if the trigger is set to every 6 hours. Similarly, if the system is complex and it would benefit to have more data, then a high initial weight values as well as an increased trigger frequency may be selected. Once the trigger frequency and the weight values of the phase connections are selected, the method 200 requires no further user input and runs passively online without interruption, i.e. continuously. The method may also provide an alert or notification to a user on a communicatively linked electrical device on the electricity distribution network when the assigned phase connection label of a meter has changed. The alert allows the user, if needed, to intervene and reconfigure the planning software or network model, or initiate a manual check of the meter.

It will be appreciated that the above described embodiments of the present invention are given by way of example only, and that various modifications may be made to the embodiments without departing from the scope of the invention as defined in the appended claims.

## Claims

1. A passive phase connection detection method for feeder power lines of an electricity distribution network, the method comprising:
acquiring (202) a list of meters for each feeder power line of the electricity distribution network; the method **characterised by**:
acquiring (202) presumed phase connection data and historic voltage data of each meter of the list of meters of each feeder power line;
assigning (202) weight values to the presumed phase connection data to each meter of the list of meters of a first feeder power line;
initiating (204) an analysis algorithm when new voltage data is detected for a first meter of the first feeder power line, wherein the analysis algorithm comprises:
calculating (206), for the first meter, the change in voltage between new voltage data and historic voltage data;
identifying (206), for the first meter, the phase connection of the meter based on the voltage difference of neighbouring meters of the list of meters of the first feeder power line that are within a predetermined threshold number of the nearest neighbour meters;
incrementing (206) the assigned weight values of the phase connection of the first meter if the identified phase connection is most common amongst the nearest neighbouring meters;
assigning (208) the meter to the phase connection with greatest assigned weight; and
repeating the analysis algorithm for a next meter of the first feeder power line.

2. The method of claim 1, wherein the analysis algorithm is performed for all feeder power lines of the electricity distribution network.

3. The method of claim 1 or 2, wherein the method is implemented online, such that the analysis algorithm processes data incrementally as new data arrive.

4. The method of any of the preceding claims, wherein the change in voltage for each meter relates to a common time interval.

5. The method of any of the preceding claims, wherein the phase is selected from the range: single-phase; two-phase; three-phase; or any suitable combination.

6. The method of any of the preceding claims, wherein the electricity distribution network is an advance metering infrastructure, AMI, network.

7. The method of any of the preceding claims, wherein the electricity distribution network consists of meters selected from the range: radio frequency, RF, meters, Wi-Fi meters, cellular-type meters or the like.

8. The method of any of the preceding claims, wherein the presumed phase connection data and historic voltage data of each meter are acquired from a database on the electricity distribution network and/or from the internal memory of the meter.

9. The method of any of the preceding claims, further comprising identifying the phase connection of a subset of meters on each feeder power line based on the meters within a predetermined threshold number of nearest neighbour meters.

10. The method of claim 9, wherein the subset of meters on each feeder power line is substantially the square root of the total meters on the feeder.

11. The method of any of the preceding claims, wherein the weight values are selected such that meters with a high degree of confidence of the presumed phase connection have a higher weight value than meters with a low degree of confidence of presumed phase connection.

12. The method of any of the preceding claims, wherein the detection of the new voltage data is set to trigger at fixed time intervals.

13. The method of claim 12, wherein the time intervals are less frequent than the data acquisition of the data stored in the database on the electricity distribution network.

14. The method of any of the preceding claims, further comprising updating the phase associations for each meter.

15. A passive phase connection detection system for feeder power lines of an electricity distribution network, the system comprising:
an electricity distribution network;
a communication module;
a data acquisition and management module;
a database;
a plurality of meters associated with a plurality of feeders; and
a computational device, wherein the computational device comprises one or more processors which are configured to perform a passive phase connection detection method as in claim 1.

## Patentansprüche

1. Passives Phasenanschlusserkennungsverfahren für Speisestromleitungen eines Elektrizitätsverteilungsnetzes, wobei das Verfahren Folgendes umfasst:
Erfassen (202) einer Liste von Zählern für jede Speisestromleitung des Elektrizitätsverteilungsnetzes; wobei das Verfahren durch Folgendes gekennzeichnet ist:
Erfassen (202) von vermuteten Phasenanschlussdaten und historischen Spannungsdaten jedes Zählers aus der Liste von Zählern jeder Speisestromleitung;
Zuweisen (202) von Gewichtswerten zu den vermuteten Phasenanschlussdaten für jeden Zähler aus der Liste von Zählern einer ersten Speisestromleitung;
Initiieren (204) eines Analysealgorithmus, wenn neue Spannungsdaten für einen ersten Zähler der ersten Speisestromleitung erkannt werden, wobei der Analysealgorithmus Folgendes umfasst:
Berechnen (206), für den ersten Zähler, der Spannungsänderung zwischen neuen Spannungsdaten und historischen Spannungsdaten;
Identifizieren (206), für den ersten Zähler, des Phasenanschlusses des Zählers basierend auf der Spannungsdifferenz von benachbarten Zählern aus der Liste von Zählern der ersten Speisestromleitung, die innerhalb einer vorbestimmten Schwellenanzahl der nächsten Nachbarzähler sind;
Inkrementieren (206) der zugewiesenen Gewichtswerte des Phasenanschlusses des ersten Zählers, wenn der identifizierte Phasenanschluss am häufigsten unter den nächsten benachbarten Zählern ist;
Zuweisen (208) des Zählers zu dem Phasenanschluss mit größtem zugewiesenen Gewicht; und
Wiederholen des Analysealgorithmus für einen nächsten Zähler der ersten Speisestromleitung.

2. Verfahren nach Anspruch 1, wobei der Analysealgorithmus für alle Speisestromleitungen des Elektrizitätsverteilungsnetzes durchgeführt wird.

3. Verfahren nach Anspruch 1 oder 2, wobei das Verfahren online implementiert ist, sodass der Analysealgorithmus Daten inkrementell verarbeitet, wenn neue Daten eintreffen.

4. Verfahren nach einem der vorhergehenden Ansprüche, wobei sich die Spannungsänderung für jeden Zähler auf ein gemeinsames Zeitintervall bezieht.

5. Verfahren nach einem der vorhergehenden Ansprüche, wobei die Phase ausgewählt ist aus dem Bereich: Einphase; Zweiphase; Dreiphase; oder einer beliebigen geeigneten Kombination.

6. Verfahren nach einem der vorhergehenden Ansprüche, wobei das Elektrizitätsverteilungsnetz ein AMI-Netz für fortschrittliche Zählerinfrastruktur ist.

7. Verfahren nach einem der vorhergehenden Ansprüche, wobei das Elektrizitätsverteilungsnetz aus Zählern ausgewählt aus dem folgenden Bereich besteht: Hochfrequenz-, RF-Zählern, Wi-Fi-Zählern, Zählern vom Zellulartyp oder dergleichen.

8. Verfahren nach einem der vorhergehenden Ansprüche, wobei die vermuteten Phasenanschlussdaten und historischen Spannungsdaten jedes Zählers aus einer Datenbank in dem Elektrizitätsverteilungsnetz und/oder aus dem internen Speicher des Zählers erfasst werden.

9. Verfahren nach einem der vorhergehenden Ansprüche, ferner umfassend Identifizieren des Phasenanschlusses eines Teilsatzes von Zählern an jeder Speisestromleitung basierend auf den Zählern innerhalb einer vorbestimmten Schwellenanzahl an nächsten Nachbarzählern.

10. Verfahren nach Anspruch 9, wobei der Teilsatz von Zählern an jeder Speisestromleitung im Wesentlichen die Quadratwurzel der gesamten Zähler an dem Speiser ist.

11. Verfahren nach einem der vorhergehenden Ansprüche, wobei die Gewichtswerte ausgewählt sind, sodass Zähler mit einem hohen Grad an Vertrauen in den vermuteten Phasenanschluss einen höheren Gewichtswert als Zähler mit einem niedrigen Grad an Vertrauen in den vermuteten Phasenanschluss aufweisen.

12. Verfahren nach einem der vorhergehenden Ansprüche, wobei die Erkennung der neuen Spannungsdaten dazu eingestellt ist, bei festen Zeitintervallen auszulösen.

13. Verfahren nach Anspruch 12, wobei die Zeitintervalle weniger häufig als die Datenerfassung der Daten sind, die in der Datenbank in dem Elektrizitätsverteilungsnetz gespeichert sind.

14. Verfahren nach einem der vorhergehenden Ansprüche, ferner umfassend Aktualisieren der Phasenassoziationen für jeden Zähler.

15. Passives Phasenanschlusserkennungssystem für Speisestromleitungen eines Elektrizitätsverteilungsnetzes, wobei das System Folgendes umfasst:
ein Elektrizitätsverteilungsnetz;
ein Kommunikationsmodul;
ein Datenerfassungs- und -verwaltungsmodul;
eine Datenbank;
eine Vielzahl von Zählern assoziiert mit einer Vielzahl von Speisern; und
eine Rechenvorrichtung, wobei die Rechenvorrichtung einen oder mehrere Prozessoren umfasst, die dazu konfiguriert sind, ein passives Phasenanschlusserkennungsverfahren nach Anspruch 1 durchzuführen.

## Revendications

1. Procédé de détection de connexion de phase passive pour des lignes électriques d'alimentation d'un réseau de distribution d'électricité, le procédé comprenant :
l'acquisition (202) d'une liste de compteurs pour chaque ligne électrique d'alimentation du réseau de distribution d'électricité ; le procédé étant **caractérisé par** :
l'acquisition (202) de données de connexion de phase présumée et de données de tension historique de chaque compteur de la liste de compteurs de chaque ligne électrique d'alimentation ;
l'attribution (202) de valeurs de poids aux données de connexion de phase présumée à chaque compteur de la liste de compteurs d'une première ligne électrique d'alimentation ;
le lancement (204) d'un algorithme d'analyse lorsque de nouvelles données de tension sont détectées pour un premier compteur de la première ligne électrique d'alimentation, ledit algorithme d'analyse comprenant :
le calcul (206), pour le premier compteur, de la variation de tension entre les nouvelles données de tension et les données de tension historiques ;
l'identification (206), pour le premier compteur, de la connexion de phase du compteur sur la base de la différence de tension de compteurs voisins de la liste de compteurs de la première ligne électrique d'alimentation qui se trouvent dans un nombre seuil prédéfini de compteurs voisins les plus proches ;
l'incrémentation (206) des valeurs de poids attribuées de la connexion de phase du premier compteur si la connexion de phase identifiée est la plus courante parmi les compteurs voisins les plus proches ;
l'attribution (208) du compteur à la connexion de phase avec le plus grand poids attribué ; et
la répétition de l'algorithme d'analyse pour un compteur suivant de la première ligne d'alimentation.

2. Procédé de la revendication 1, ledit algorithme d'analyse étant réalisé pour toutes les lignes électriques d'alimentation du réseau de distribution d'électricité.

3. Procédé de la revendication 1 ou 2, ledit procédé étant mis en œuvre en ligne, de sorte que l'algorithme d'analyse traite des données de manière incrémentielle à mesure que de nouvelles données arrivent.

4. Procédé de l'une quelconque des revendications précédentes, ledit changement de tension pour chaque compteur se rapportant à un intervalle de temps commun.

5. Procédé de l'une quelconque des revendications précédentes, ladite phase étant sélectionnée dans la plage : monophasée ; biphasée ; triphasée ; ou toute combinaison appropriée.

6. Procédé de l'une quelconque des revendications précédentes, ledit réseau de distribution d'électricité étant un réseau d'infrastructure de mesure avancée, AMI.

7. Procédé de l'une quelconque des revendications précédentes, ledit réseau de distribution d'électricité étant constitué de compteurs sélectionnés dans la plage : compteurs radiofréquence, RF, compteurs Wi-Fi, compteurs de type cellulaire ou similaire.

8. Procédé de l'une quelconque des revendications précédentes, lesdites données de connexion de phase présumée et lesdites données de tension historiques de chaque compteur étant acquises à partir d'une base de données sur le réseau de distribution d'électricité et/ou à partir de la mémoire interne du compteur.

9. Procédé de l'une quelconque des revendications précédentes, comprenant en outre l'identification de la connexion de phase d'un sous-ensemble de compteurs sur chaque ligne électrique d'alimentation sur la base des compteurs dans un nombre seuil prédéfini de compteurs voisins les plus proches.

10. Procédé de la revendication 9, ledit sous-ensemble de compteurs sur chaque ligne électrique d'alimentation étant sensiblement la racine carrée des compteurs totaux sur l'alimentation.

11. Procédé de l'une quelconque des revendications précédentes, lesdites valeurs de poids étant sélectionnées de sorte que des compteurs avec un degré élevé de confiance de la connexion de phase présumée possèdent une valeur de poids plus élevée que les compteurs avec un faible degré de confiance de la connexion de phase présumée.

12. Procédé de l'une quelconque des revendications précédentes, ladite détection des nouvelles données de tension étant réglée pour se déclencher à des intervalles de temps fixes.

13. Procédé de la revendication 12, lesdits intervalles de temps étant moins fréquents que l'acquisition de données des données stockées dans la base de données sur le réseau de distribution d'électricité.

14. Procédé de l'une quelconque des revendications précédentes, comprenant en outre la mise à jour des associations de phase pour chaque compteur.

15. Système de détection de connexion de phase passive pour des lignes électriques d'alimentation d'un réseau de distribution d'électricité, le système comprenant :
un réseau de distribution d'électricité ;
un module de communication ;
un module d'acquisition et de gestion de données ;
une base de données ;
une pluralité de compteurs associés à une pluralité d'alimentations ; et
un dispositif de calcul, ledit dispositif de calcul comprenant un ou plusieurs processeurs qui sont configurés pour réaliser un procédé de détection de connexion de phase passive selon la revendication 1.
